Europäisches Patentamt

European Patent Office

Office européen des brevets

(11) Publication number: **0 271 283 B1**

# EUROPEAN PATENT SPECIFICATION

(45) Date of publication of patent specification: **25.11.92**  (51) Int. Cl.⁵: **G11C 11/41**

(21) Application number: **87310634.8**

(22) Date of filing: **03.12.87**

(54) **Static semiconductor memory device having improved pull-up operation for bit lines.**

(30) Priority: **06.12.86 JP 289756/86**

(43) Date of publication of application:
**15.06.88 Bulletin  88/24**

(45) Publication of the grant of the patent:
**25.11.92 Bulletin  92/48**

(84) Designated Contracting States:
**DE FR GB**

(56) References cited:
**GB-A- 2 163 616**
**US-A- 3 638 039**

**IBM TECHNICAL DISCLOSURE BULLETIN, vol. 26, no. 7A, December 1983, pages 3507-3509, New York, US; N.G. THOMA: "Precharge circuit for static random-access memory arrays"**

**IEEE JOURNAL OF SOLID-STATE CIRCUITS, vol. SC-18, no. 5, October 1983, pages 612-614, New York, US; B.A. FREDERICK: "A fast 16K static RAM built with a silicide enhanced NMOS process"**

(73) Proprietor: **FUJITSU LIMITED**
**1015, Kamikodanaka Nakahara-ku**
**Kawasaki-shi Kanagawa 211(JP)**

(72) Inventor: **Kawashima, Shoichiro**
**54 Minami Kibogaoka Asahi-ku**
**Yokohama-shi Kanagawa 241(JP)**

(74) Representative: **Rackham, Stephen Neil et al**
**GILL JENNINGS & EVERY 53-64 Chancery Lane**
**London WC2A 1HN(GB)**

## Description

The present invention relates to a static semiconductor memory device, and more particularly, to an improvement of a pull-up operation for bit line pairs.

In general, in a metal-oxide-semiconductor (MOS) static memory device, static memory cells are provided at each intersection of word lines, and bit line pairs. All the bit lines are connected via load transistors to a power supply, and in this case, the load transistors serve as pull-up means for the bit line pairs. When a word line and a bit line pair are selected to read data from a memory cell at the intersection thereof, a load current flows through the memory cell. In this case, also in the non-selected memory cells (hereinafter, referred to as half-selected cells) connected to the selected word line, similar load currents flow therethrough. However, no load currents flow through the non-selected cells connected to the non-selected word lines. Further, when writing data into the selected memory cell, one bit line of the selected bit line pair is pulled down to a level such as the ground level, so that a large load current flows through a path including the one bit line, thus increasing the power consumption during a write-mode.

In order to reduce the above-mentioned power consumption during a write mode, a static semiconductor memory device is known from Yamamoto et al. "A 256KCMOS SPRAM with Variable Impedance Loads", ISSCC DIGEST OF TECHNICAL PAPERS, P. 58, 59, Feb. 1985. In this static memory device, however, there is a possibility that the contents of the next half-selected memory cells will be reversed, which will be later explained in detail.

In GB-A-2163616 a memory device according to the preamble of claim 1 is disclosed. In this device each bit line pair may be selectively short-circuited to reduce the potential between the lines to increase the speed of the memory device.

An object of the present invention is to provide a static semiconductor memory device which carries out a pull-up operation while stabilizing the state of the memory cells.

According to the present invention, a semiconductor memory device comprises:

static memory cells, provided at each intersection between a plurality of word lines and a plurality of bit line pairs;

suppressing means provided at each of said bit line pairs, for suppressing the reduction of the potential of the lower level bit line of each bit line pair;

word line selection means for selecting one of the word lines;

bit line pair selection means for selection one bit line pair and prohibiting the suppressing operation of the reduction of the potential of the lower level bit line of that pair by the suppressing means, characterised in that the suppressing means includes:

a connection line provided at the bit line pairs; and,

a plurality of transistors, connected between the bit line pairs and the connection line, the transistors being turned ON when the corresponding bit line pairs are not selected by the bit line pair selection means, wherein said connection line is in a floating state when all of said transistors are turned OFF.

The present invention will be more clearly understood from the description as set forth below, and in contrast with the prior art, with reference to the accompanying drawings, in which:-

Figures 1 and 3 are circuit diagrams illustrating prior art static semiconductor memory devices;

Figure 2 is a partial detailed diagram of Figure 1; and,

Figures 4, 5 and 6 are circuit diagrams illustrating embodiments of the static semiconductor memory device according to the present invention.

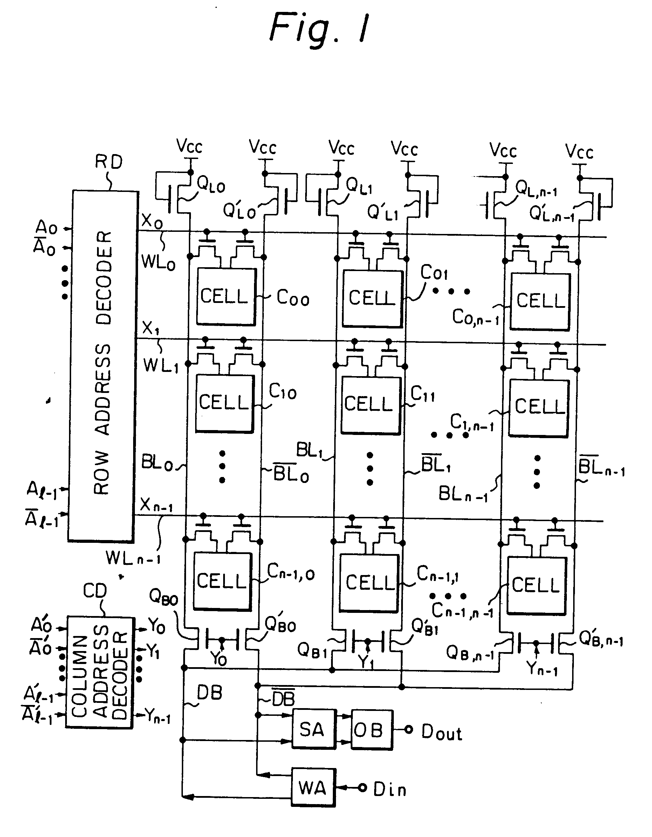

First, the prior art static semiconductor memory devices will be explained with reference to Figures 1 to 3.

In Figure 1, which illustrates a prior art static semiconductor memory device, static memory cells, $C_{00}$, $C_{01}$, ..., $C_{n-1,n-1}$ are provided at each intersection of word lines $WL_0$, $WL_1$, ..., and $WL_{n-1}$ and bit line pairs $BL_0$, $\overline{BL_0}$; $BL_1$, $\overline{BL_1}$; ...; and $BL_{n-1}$, $\overline{BL_{n-1}}$. One word line and one bit line pair are selected by row selection signals $X_0$, $X_1$, ..., and $X_{n-1}$ of a row address decoder RD and column selection signals $Y_0$, $Y_1$, ..., and $Y_{n-1}$ of a column address decoder CD, i.e., one memory cell is selected. In Fig. 1, column selection gates $Q_{B0}$, $Q_{B0}'$; $Q_{B1}$, $Q_{B1}'$; ...; and $Q_{B,n-1}$, $Q_{B,n-1}'$ are controlled by the column selection signals $Y_0$, $Y_1$, ..., and $Y_{n-1}$. All the bit lines $BL_0$, $\overline{BL_0}$, $BL_1$, $\overline{BL_1}$, ..., $BL_{n-1}$, $\overline{BL_{n-1}}$ are connected via load transistors $Q_{L0}$, $Q_{L0}'$, $Q_{L1}$, $Q_{L1}'$, ..., and $Q_{L,n-1}$, $Q_{L,n-1}'$ to a power supply $V_{CC}$, and are also connected via column selection gates $Q_{B0}$, $Q_{B0}'$, $Q_{B1}$, $Q_{B1}'$, ..., $Q_{B,n-1}$, $Q_{B,n-1}'$ to a sense amplifier SA (output buffer OB) and a write amplifier WA. DB and $\overline{DB}$ designate data buses, $D_{out}$ an output data, and $D_{in}$ an input data.

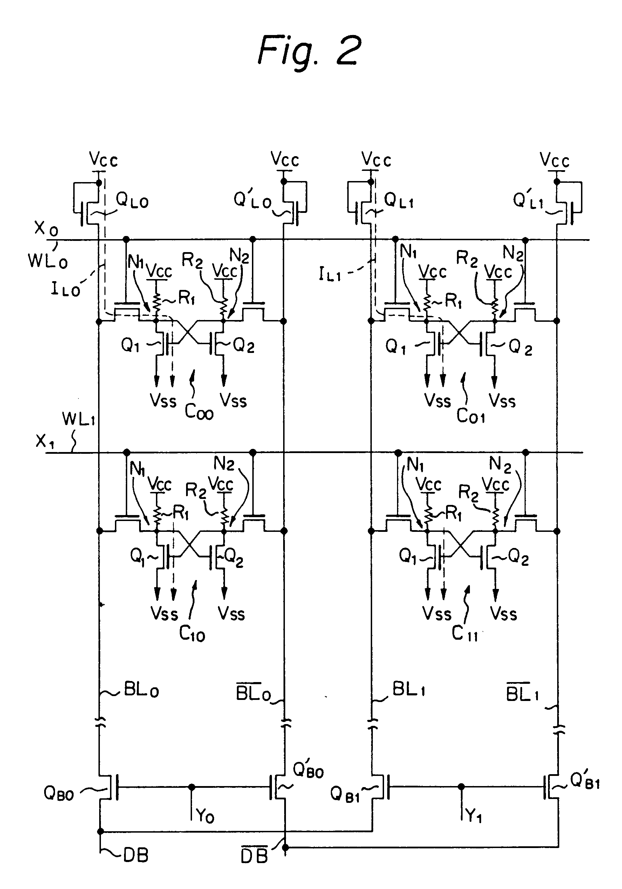

As illustrated in Fig. 2, the memory cells $C_{00}$, $C_{01}$, ... of Fig. 1 comprise loads $R_1$ and $R_2$ - (resistors, drain-gate connected enhancement type N-channel transistors, or source-gate connected depletion type N-channel transistors), and a pair of cross-coupled transistors $Q_1$ and $Q_2$. In Fig. 2, when the memory cell $C_{00}$ is selected in order to read data therefrom, the row selection signal $X_0$ is

made high and the column selection signal $Y_0$ is made high. As a result, in the selected cell $C_{00}$, if the transistors $Q_1$ and $Q_2$ are turned ON and OFF, respectively, a load current $I_{L0}$ flows. In this case, also in the non-selected cells (hereinafter, referred to as half-selected cells) connected to the selected word line $WL_0$, similar load currents $I_{L1}$ flow therethrough. However, no load currents flow through the non-selected cells $C_{10}$ and $C_{11}$. Further, when writing data into the memory cell $C_{00}$, one of the selected bit lines $BL_0$ and $\overline{BL_0}$, such as the bit line $BL_0$ is pulled down to a $V_{SS}$ level, so that a large load current flows through a path $V_{CC} \rightarrow Q_{L0} \rightarrow BL_0 \rightarrow DB$. Therefore, a problem arises in that the power consumption during a write mode is increased.

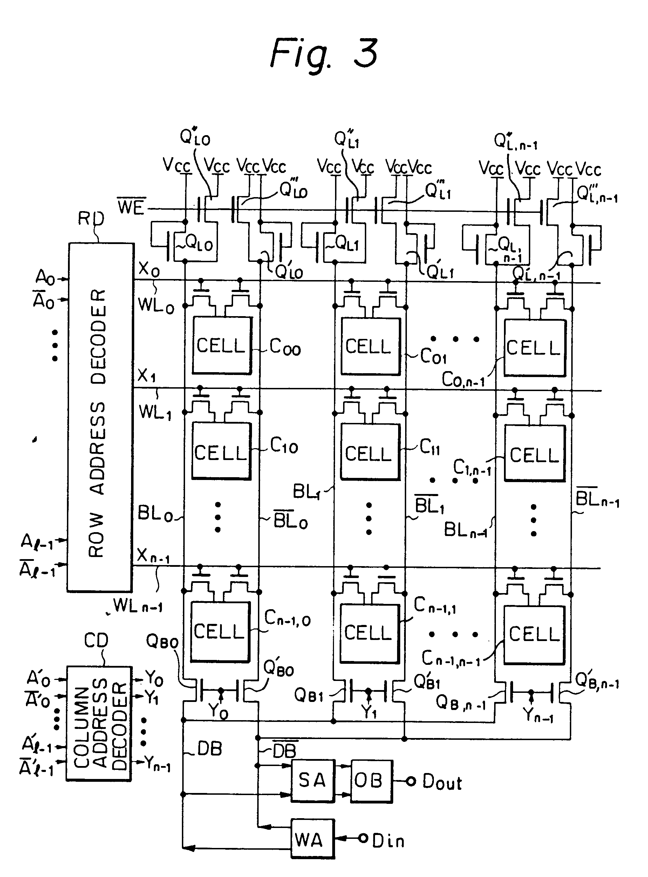

In order to reduce the above-mentioned power consumption during a write mode, a static semiconductor memory device as illustrated in Fig. 3 is known (see Yamamoto et al. "A 256KCMOS SRAM with Variable Impedance Loads", ISSCC DIGEST OF TECHNICAL PAPERS, P. 58, 59 Feb. 1985). That is, in Fig. 3, load transistors $Q_{L0}''$, $Q_{L0}'''$, $Q_{L1}''$, $Q_{L1}'''$, ..., $Q_{L,n-1}''$, $Q_{L,n-1}'''$ controlled by a write enable signal $\overline{WE}$ are added to the load transistors $Q_{L0}$, $Q_{L0}'$, $Q_{L1}$, $Q_{L1}'$, ..., and $Q_{L,n-1}$, $Q_{L,n-1}'$ which serve as steady pull-up means. Therefore, during a read mode ($\overline{WE}$ = "1"), load currents from the transistors $Q_{L0}''$, $Q_{L0}'''$, $Q_{L1}''$, $Q_{L1}'''$, ..., $Q_{L,n-1}''$, $Q_{L,n-1}'''$ in addition to load currents from the transistors $Q_{L0}$, $Q_{L0}'$, $Q_{L1}$, $Q_{L1}'$, ..., And $Q_{L,n-1}$, $Q_{L,n-1}'$ are supplied to the bit lines $BL_0$, $\overline{BL_0}$, $BL_1$, $\overline{BL_1}$, ..., and $BL_{n-1}$, $\overline{BL_{n-1}}$. During a write mode ($\overline{WE}$ = "0"), only load currents from the transistors $Q_{L0}$, $Q_{L0}'$, $Q_{L1}$, $Q_{L1}'$, ..., $Q_{L,n-1}$, $Q_{L,n-1}'$ are supplied to the bit lines $BL_0$, $\overline{BL_0}$, $BL_1$, $\overline{BL_1}$, ..., $BL_{n-1}$, $\overline{BL_{n-1}}$. Note that the size of the transistors $Q_{L0}$, $Q_{L0}'$, $Q_{L1}$, $Q_{L1}'$, ..., and $Q_{L,n-1}$, $Q_{L,n-1}'$ can be reduced compared with those of Fig. 1. Therefore, during a write mode, the load current supplied to one of the selected bit lines such as $BL_0$ and $\overline{BL_0}$ can be reduced, compared with the device of Fig. 1.

In the circuit of Fig. 3, however, since the load current supplied to the non-selected bit lines $BL_1$, $\overline{BL_1}$, ..., and $BL_{n-1}$, $\overline{BL_{n-1}}$ is smaller during a write mode than during a read mode, a problem arises in that the contents of the non-selected cells may be reversed. For example, it is assumed that a write operation is performed upon the memory cell $C_{00}$. Then, the row selection signal $X_0$ and the column selection signal $Y_0$ are made high, and in addition, one of the selected bit lines such as $BL_0$ is made low and the other $\overline{BL_0}$ is made high, thus performing a write operation upon the memory cell $C_{00}$. At this time, the half-selected cells $C_{01}$, $C_{02}$, ..., and $C_{0,n-1}$ are also connected to the respective bit lines $BL_1$, $\overline{BL_1}$, $BL_2$, $\overline{BL_2}$, ..., and $BL_{n-1}$, $\overline{BL_{n-1}}$. Therefore, for example, in the memory cell $C_{01}$, if the left-side

transistor $Q_1$ is turned ON and the right-side transistor $Q_2$ is turned OFF, a pull-up operation for the bit lines $BL_1$ and $\overline{BL_1}$ is carried out by only the transistors $Q_{L1}$ and $Q_{L1}'$. Therefore, the potential at the bit line $BL_1$ may be excessively reduced. As a result, when the selected word line is transferred from $WL_0$ to $WL_1$, the transistor $Q_1$ of the half-selected cell $C_{11}$ is forcibly turned OFF, regardless of the state thereof, thereby turning ON the transistor $Q_2$. That is, there is a possibility that the contents of the next half-selected memory cells will be reversed.

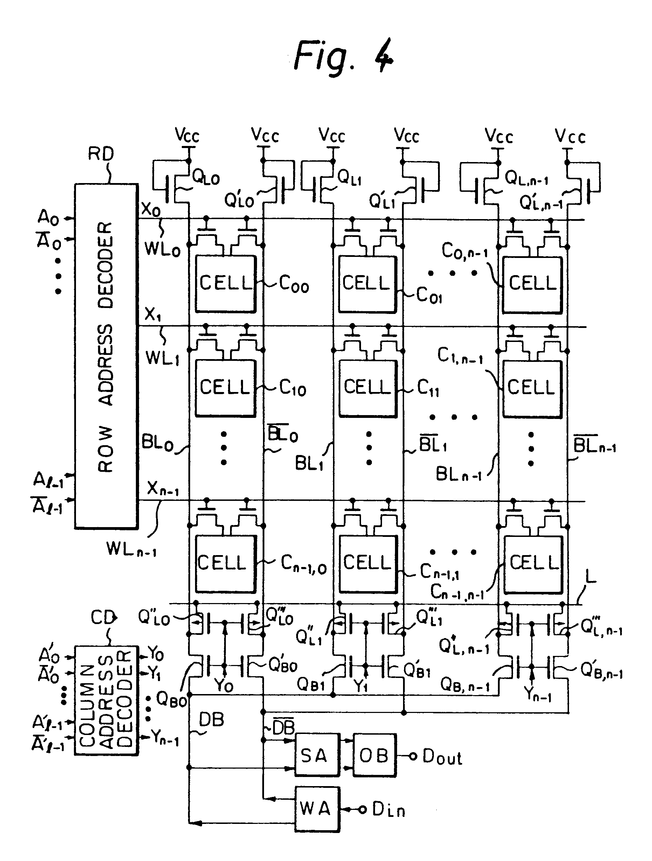

Figure 4 illustrates a first example of the present invention in which the load transistors $Q_{L0}$, $Q_{L0}'$, $Q_{L1}$, $Q_{L1}'$, ..., $Q_{L,n-1}$, $Q_{L,n-1}'$ act as the pull-up means of Figure 1. In Fig. 4, a connection line L and transistors $Q_{L0}''$, $Q_{L0}'''$, $Q_{L1}''$, $Q_{L1}'''$, ..., $Q_{L,n-1}''$, $Q_{L,n-1}'''$ (in this case, P-channel transistors) between the line L and the bit lines $BL_0$, $\overline{BL_0}$, $BL_1$, $\overline{BL_1}$, ..., and $BL_{n-1}$, $\overline{BL_{n-1}}$ are provided. Further, these transistors $Q_{L0}''$, $Q_{L0}'''$, $Q_{L1}''$, $Q_{L1}'''$, ..., and $Q_{L,n-1}''$, $Q_{L,n-1}'''$ are controlled by the column selection signals $Y_0$, $Y_1$, ..., and $Y_{n-1}$. That is, in this case, the common connection line L holds the mean potential of all the bit lines (precisely, the non-selected bit lines), and equalizes the potentials of all the non-selected bit lines. Note that the size of the load transistors $Q_{L0}$, $Q_{L0}'$, $Q_{L1}$, $Q_{L1}'$, ..., $Q_{L,n-1}$, $Q_{L,n-1}'$, can be reduced compared with those of Fig. 1.

In Fig. 4, when the bit lines $BL_0$ and $\overline{BL_0}$ are selected, the column selection signal $Y_0$ is high and the other column selection signals $Y_1$ to $Y_{n-1}$ are low. Therefore, the transistors $Q_{L0}''$ and $Q_{L0}'''$ are turned OFF and the transistors $Q_{B0}$ and $Q_{B0}'$ are turned ON, so that the bit lines $BL_0$ and $\overline{BL_0}$ are connected to the data buses DB and $\overline{DB}$, respectively. In a write mode, when the data bus DB is caused to be low by the write amplifier WA, a current flows through a path: $Q_{L0} \rightarrow BL_0 \rightarrow Q_{B0} \rightarrow DB$. Even in this case, however, the power consumption can be reduced due to the reduced size of the load transistors $Q_{L0}$ and $Q_{L0}'$ as compared with the prior art. On the other hand, all the transistors $Q_{B1}$, $Q_{B1}'$, ..., and $Q_{B,n-1}$, $Q_{B,n-1}'$ are turned OFF and all the transistors $Q_{L1}''$, $Q_{L1}'''$, ..., and $Q_{L,n-1}''$, $Q_{L,n-1}'''$ are turned ON. As a result, the non-selected bit lines $BL_1$, $\overline{BL_1}$, ..., $BL_{n-1}$, $\overline{BL_{n-1}}$ are commonly connected by the connection line L, and therefore, the potentials of these non-selected bit lines are equalized.

The advantage of provision of the connection line L will be explained. In Fig. 4, if the size of the load transistors $Q_{L0}$, $Q_{L0}'$, ..., and $Q_{L,n-1}$, $Q_{L,n-1}'$ is reduced, the pull-up power for the bit lines is small. Therefore, when the bit lines $BL_0$ and $\overline{BL_0}$ are changed from a selected state to a non-selected state after one of the bit lines such as $BL_0$ is caused to be low by the write amplifier WA, the bit

line BL$_0$ is not rapidly pulled up by the load transistors Q$_{LO}$ and Q$_{LO}$'. In Fig. 4, however, the lower potential at the bit line BL$_0$ is pulled up by the potential at the connection line L due to the change of the transistors Q$_{LO}$" and Q$_{LO}$''' from an OFF state to an ON State. Note that the potential at the connection line L is always relatively high, since a mean value of the potentials at the non-selected bit lines are higher than a mean value of the potentials at the selected bit lines. In this case, the total load currents in the non-selected bit lines are the same during a read mode as during a write mode.

Thus, also in the circuit of Fig. 4, during a write mode, the load currents in the selected bit lines are reduced, thus improving the power consumption, and the load currents in the non-selected bit lines are the same during a read mode as during a write mode. As a result, in the non-selected bit lines, even when the half-selected cells are changed, there is little possibility that the data of the previous half-selected cells will rewrite the data of the next half-selected cells.

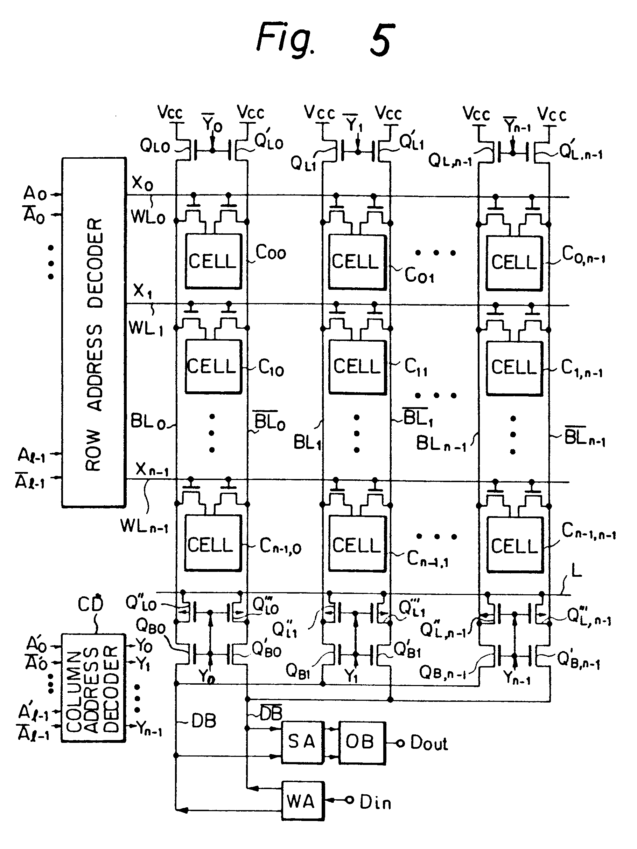

In a second example of a semiconductor memory device according to this invention, as shown in Figure 5, in addition to the connecting line of the first example, the semiconductor memory also includes load transistors Q$_{L0}$, Q$_{L0}$', Q$_{L1}$, Q$_{L1}$', ..., Q$_{L,n-1}$, Q$_{L,n-1}$' as the pull-up means of Fig. 1 which are controlled by the column selection signals $\overline{Y}_0$, $\overline{Y}_1$, ..., and $\overline{Y}_{n-1}$. That is, no load current is supplied to the bit lines such as BL$_0$ and $\overline{BL}_0$ when the level of the inverted column selection signal $\overline{Y}_0$ is low. In this case, during a read mode, the selected Bl$_0$ and $\overline{BL}_0$ are connected by the column selection gates Q$_{B0}$ and Q$_{B0}$' to the data buses DB and $\overline{DB}$, and accordingly, the selected bit lines BL$_0$ and $\overline{BL}_0$ are pulled up by the pull-up means incorporated into the sense amplifier SA. Also, during a write mode, one of the data buses DB and $\overline{DB}$ is made low and the other is made high by the write amplifier WA, and accordingly, a write operation is performed upon the selected cell such as C$_{00}$ by the data buses DB and $\overline{DB}$, the column selection gates Q$_{B0}$ and Q$_{B0}$', and the bit lines BL$_0$ and $\overline{BL}_0$. On the other hand, since the transistors Q$_{L1}$, Q$_{L1}$', ..., and Q$_{L,n-1}$, Q$_{L,n-1}$' are turned ON when the inverted column selection signals $\overline{Y}_1$, ..., and $\overline{Y}_{n-1}$ are high. Therefore, load currents are supplied to the non-selected bit lines such as BL$_1$, $\overline{BL}_1$, ..., and BL$_{n-1}$, $\overline{BL}_{n-1}$. Also, in this case, the load currents are the same during a write mode as during a read mode.

Thus, in the circuit of Fig. 5, during a write mode, the load currents in the selected bit lines are reduced, thus reducing the power consumption, and the load currents in the non-selected bit lines are the same during a read mode as during a write mode. As a result, in the non-selected bit lines, even when the half-selected cells are changed, there is little possibility that the data of the previous half-selected cells will rewrite the data of the next half-selected cells.

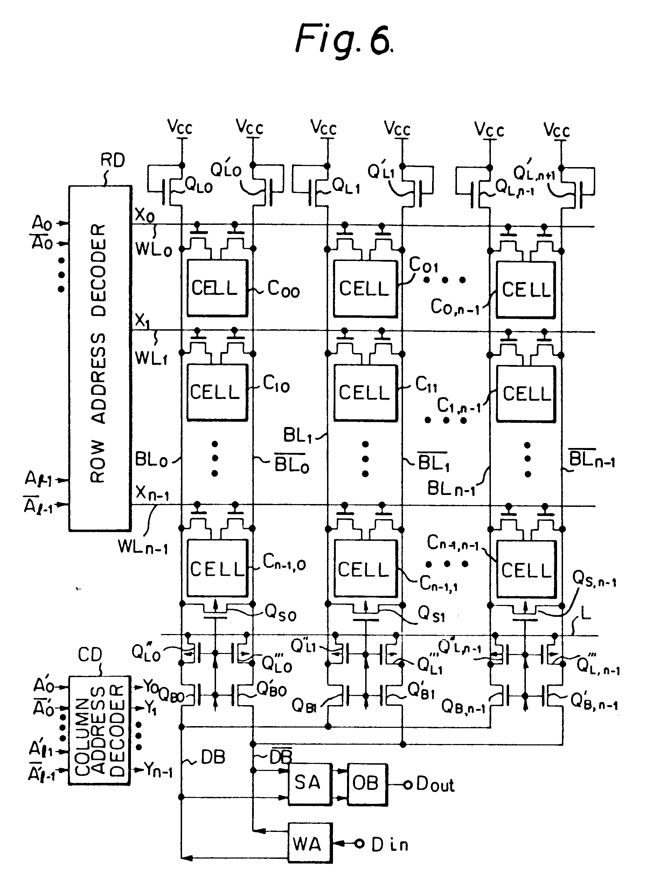

Figure 6 illustrates a third example of the present invention. In addition to the connecting line L of the first embodiment, the semiconductor memory also includes bit line short-circuiting transistors Q$_{S0}$, Q$_{S1}$, ..., Q$_{S,n-1}$ (in this case, P-channel transistors) which are provided for each pair of the bit line pairs BL$_0$, $\overline{BL}_0$, BL$_1$, $\overline{BL}_1$; ...; and BL$_{n-1}$, $\overline{BL}_{n-1}$, and these transistors Q$_{S0}$, Q$_{S1}$, ..., and Q$_{S,n-1}$ are controlled by the column selection signals Y$_0$, Y$_1$, ..., and Y$_{n-1}$.

In Fig. 6, both in the selected and non-selected bit lines, load currents are supplied from the transistors Q$_{L0}$, Q$_{L0}$', Q$_{L1}$, Q$_{L1}$', ..., and Q$_{L,n-1}$, Q$_{l,n-1}$'. In the selected bit lines BL$_0$ and $\overline{BL}_0$, the transistor Q$_{S0}$ is turned OFF, and in the non-selected bit lines BL$_1$, $\overline{BL}_1$, ..., and BL$_{n-1}$, $\overline{BL}_{n-1}$, the transistors Q$_{S1}$, ..., and Q$_{S,n-1}$ are turned ON, thus equalizing the potential between each pair of the non-selected bit line pairs. Thus, also in the circuit of Fig. 6, in the non-selected bit lines, even when the half-selected cells are changed, there is little possibility that the data of the previous half-selected cells will rewrite the data of the next half-selected cells.

In Fig. 6, the potential at the lower bit lines of the non-selected bit line pairs are further increased, to avoid the reversion of the contents of the next half-selected cells.

Note that, in the above-mentioned embodiments, the type of transistors is not limited, and of course, P-channel type transistors and N-channel type transistors can be used as occasion demands.

As explained above, according to the present invention, the power consumption can be reduced, and in addition, since the load currents in the non-selected bit lines, i.e., the pull-up power, is the same, during a read mode as during a write mode, even when the half-selected cells are changed in the non-selected bit lines, there is little possibility that the data of the previous half-selected cells will rewrite the data of the next half-selected cells, thus avoiding the reversion of the contents of memory cells.

**Claims**

1.  A semiconductor memory device comprising:
    static memory cells (C$_{00}$, C$_{01}$, ...), provided at each intersection between a plurality of word lines (WL$_0$, WL$_1$, ...) and a plurality of bit line pairs (BL$_0$, $\overline{BL}_0$, ...);
    suppressing means provided at each of said bit line pairs, for suppressing the reduction of the potential of the lower level bit line of each bit line pair;
    word line selection means (RD) for selecting one of the word lines;

bit line pair selection means for selection one bit line pair and prohibiting the suppressing operation of the reduction of the potential of the lower level bit line of that pair by the suppressing means, characterised in that the suppressing means includes:

a connection line (L) provided at the bit line pairs; and,

a plurality of transistors ($Q_{L0}$", $Q_{L0}$"', ..., $Q_{L,n-1}$", $Q_{L,n-1}$"'), connected between the bit line pairs and the connection line, the transistors being turned ON when the corresponding bit line pairs are not selected by the bit line pair selection means, wherein said connection line (L) is in a floating state when all of said transistors ($Q_{L0}$", $Q_{L0}$"', ..., $Q_{L,n-1}$", $Q_{L,n-1}$"') are turned OFF.

2. A device according to claim 1, wherein the suppressing means includes load transistors ($Q_{L0}$, $Q_{L0}$', ..., $Q_{L,n-1}$, $Q_{L,n-1}$'), connected between the bit line pairs and a power supply, the load transistors being turned ON when the corresponding bit line pairs are not selected by the bit line pair selection means.

3. A device according to claim 1 or 2, wherein the suppressing means includes bit line short-circuiting means ($Q_{S0}$, $Q_{S1}$, ...), provided for each of the bit line pairs, for suppressing the reduction of the potential of the lower level bit lines of the bit line pairs, the bit line short-circuiting means being turned ON when the corresponding bit line pairs are not selected by the bit line selection means.

**Patentansprüche**

1. Halbleiterspeicheranordnung mit:

statischen Speicherzellen ($C_{00}$, $C_{01}$, ...), die an jede Schnittpunkt zwischen einer Vielzahl von Wortleitungen ($WL_0$, $WL_1$, ...) und einer Vielzahl von Bitleitungspaaren ($BL_0$, $BL_0$, ...) vorgesehen sind;

einer an jedem der genannten Bitleitungspaare vorgesehenen Unterdrückungseinrichtung zum Unterdrücken der Potentialverminderung der Bitleitung mit niedrigerem Pegel jedes Bitleitungspaares;

einer Wortleitungsauswahleinrichtung (RD) zum Auswählen einer der Wortleitungen;

einer Bitleitungsauswahleinrichtung zum Wählen eines Bitleitungspaares und Hindern des Unterdrückungsvorgangs der Potentialverminderung der Bitleitung mit niedrigerem Pegel dieses Paares durch die Unterdrückungseinrichtung, dadurch gekennzeichnet, daß die Unterdrückungseinrichtung enthält:

eine an den Bitleitungspaaren vorgesehene Verbindungsleitung (L); und

eine Vielzahl von Transistoren ($Q_{L0}$", $Q_{L0}$"', ..., $Q_{L,n-1}$", $Q_{L,n-1}$"'), die zwischen den Bitleitungspaaren und der Verbindungsleitung angeschlossen sind, bei der die Transistoren EIN geschaltet sind, wenn die entsprechenden Bitleitungspaare durch die Bitleitungspaar-Auswahleinrichtung nicht ausgewählt werden, und bei der sich die genannte Verbindungsleitung (L) in einem Schwebezustand befindet, wenn alle der genannten Transistoren ($Q_{L0}$", $Q_{L0}$"', ..., $Q_{L,n-1}$", $Q_{L,n-1}$"') AUS geschaltet sind.

2. Anordnung nach Anspruch 1, hei welcher die Unterdrückungseinrichtung Lasttransistoren ($Q_{L0}$, $Q_{L0}$', ..., $Q_{L,n-1}$, $Q_{L,n-1}$') enthält, die zwischen den Bitleitungspaaren und einer Stromzufuhr angeschlossen sind, wobei die Lasttransistoren EIN geschaltet sind, wenn die entsprechenden Bitleitungspaare nicht durch die Bitleitungspaar-Auswahleinrichtung ausgewählt werden.

3. Anordnung nach Anspruch 1 oder 2, bei welcher die Unterdrückungseinrichtung eine für jedes der Bitleitungspaare vorgesehene Bitleitungs-Kurzschließeinrichtung ($Q_{S0}$, $Q_{S1}$, ...) zum Unterdrücken der Potentialverminderung der Bitleitungen mit niedrigerem Potential der Bitleitungspaare enthält, wobei die Bitleitungs-Kurzschließeinrichtung EIN geschaltet ist, wenn die entsprechenden Bitleitungspaare nicht durch die Bitleitungsauswahleinrichtung ausgewählt werden.

**Revendications**

1. Dispositif de mémoire à semiconducteur comprenant:

des cellules de mémoire statique ($C_{00}$, $C_{01}$, ...), prévues à chaque intersection entre une pluralité de fils de mot ($WL_0$, $WL_1$, ...) et une pluralité de paires de fils de bit ($BL_0$, $\overline{BL_0}$, ...);

des moyens de suppression prévus sur chacune desdites paires de fils de bit, pour supprimer la réduction du potentiel du fil de bit de niveau inférieur de chaque paire de fils de bit;

un moyen de sélection de fil de mot (RD) pour sélectionner un des fils de mot;

un moyen de sélection de paire de fils de bit pour la sélection d'une paire de fils de bit et l'interdiction de l'opération de suppression de la réduction du potentiel du fil de bit de niveau inférieur de cette paire par les moyens de suppression,

caractérisé en ce que les moyens de suppression comprennent:

un fil de connexion (L) prévu sur les paires de fils de bit; et,

une pluralité de transistors ($Q_{L0}$'', $Q_{L0}$''',..., $Q_{L,n-1}$'', $Q_{L,n-1}$'''), connectés entre les paires de fils de bit et le fil de connexion, les transistors étant rendus conducteurs quand les paires de fils de bit correspondantes ne sont pas sélectionnées par le moyen de sélection de paire de fils de bit, où ledit fil de connexion (L) est dans un état flottant quand tous les transistors ($Q_{L0}$'', $Q_{L0}$''',..., $Q_{L,n-1}$'', $Q_{L,n-1}$''') sont bloqués.

2. Dispositif selon la revendication 1, dans lequel les moyens de suppression comprennent des transistors de charge ($Q_{L0}$, $Q_{L0}$',..., $Q_{L,n-1}$, $Q_{L,n-1}$'), connectés entre les paires de fils de bit et une source de tension d'alimentation, les transistors de charge étant rendus conducteurs quand les paires de fils de bit correspondantes ne sont pas sélectionnées par le moyen de sélection de paire de fils de bit.

3. Dispositif selon l'une quelconque des revendications 1 et 2, dans lequel les moyens de suppression comprennent des moyens de mise en court-circuit des fils de bit ($Q_{S0}$, $Q_{S1}$,...), prévus pour chacune des paires de fils de bit, pour supprimer la réduction du potentiel des fils de bit de niveau inférieur des paires de fils de bit, les moyens de mise en court-circuit des fils de bit étant rendus conducteurs quand les paires de fils de bit correspondantes ne sont pas sélectionnées par le moyen de sélection de paire de fils de bit.

EP 0 271 283 B1

# Fig. 1

7

# Fig. 2

# Fig. 3

## Fig. 4

# Fig. 5

Fig. 6.